# EUROPEAN PATENT APPLICATION

(11) **EP 4 734 680 A1**
(43) Date of publication of application: **29.04.2026**
(21) Application number: 24831785.1
(22) Date of filing: 19.06.2024
(51) Int. Cl.: H05K 7/20, H01M 10/613, H01M 10/647, H01M 10/655, H01M 50/204

(54) **HEAT CONDUCTING STRUCTURE**

(30) Priority: 26.06.2023 JP 2023104284
(71) Applicant: NOK Corporation, Minato-ku Tokyo 105-8585 (JP)
(72) Inventor: YOSHIDA, Yusuke, Kitaibaraki-shi, Ibaraki 319-1535 (JP); WAKABAYASHI, Yusaku, Utsunomiya-shi, Tochigi 320-0811 (JP)
(74) Representative: Global IP Europe Patentanwaltskanzlei
(86) International application number: PCT/JP2024/022182
(87) International publication number: WO 2025/004923

(57) **Abstract**

A heat conduction structure (1) includes a soft thermally conductive member (10) that is a soft member with thermally conductive properties. The soft thermally conductive member (10) is a member able to maintain a shape. The soft thermally conductive member (10) is packed between the heat-dissipating member (2) and the receiving member (3) .

## Description

### [Technical Field]

The present invention relates to a heat conduction structure.

### [Background Art]

For example, in order to increase the cruising distance of electric vehicles (EVs), downsizing and increase in output power of a powertrain are required to achieve a high efficiency of the powertrain, such as a motor, a battery, and an inverter. Achieving downsizing, increase in output power, or both of the powertrain necessitates an increase in heat generation density. In response to the increase in heat generation density, for example, Patent Literature 1 discloses an adhesive agent designed to maintain a bonding strength even when immersed in a high-temperature electrolyte solution.

### [Citation List]

### [Patent Literature]

Patent Literature 1: Japanese Patent Laid-Open No. 2018-161895

### [Summary of the Invention]

### [Technical Problem]

As seen from the above, a variety of materials and substances are proposed in order to address an increase in heat generation density. Meanwhile, in response to the increase in heat generation density, a further improvement in heat dissipation technology is required.

The present invention is made in view of the above-described problem and an object of the present invention is to provide a heat conduction structure that enables a favorable heat dissipation.

### [Solution to Problem]

In order to achieve the above-described object, a heat conduction structure according to the present invention is a heat conduction structure for conducting heat of a heat-dissipating member to a receiving member, the heat conduction structure including a soft thermally conductive member that is a soft member with thermally conductive properties, in which the soft thermally conductive member is a member able to maintain a shape, and the soft thermally conductive member is packed between the heat-dissipating member and the receiving member.

In the heat conduction structure according to an aspect of the present invention, a thermal conductivity of the soft thermally conductive member is lower than a thermal conductivity of the heat-dissipating member.

In the heat conduction structure according to an aspect of the present invention, the soft thermally conductive member is a composition in paste form with thermally conductive properties.

In the heat conduction structure according to an aspect of the present invention, the soft thermally conductive member includes a grease and thermally conductive particles.

In the heat conduction structure according to an aspect of the present invention, the receiving member is made of a resin with thermally conductive properties, and a thermal conductivity of the receiving member is lower than a thermal conductivity of the heat-dissipating member.

In the heat conduction structure according to an aspect of the present invention, the heat-dissipating member and the receiving member include respective thermal connection portions that are portions for mutual thermal connection, and the soft thermally conductive member is packed between the thermal connection portion of the heat-dissipating member and the thermal connection portion of the receiving member.

In the heat conduction structure according to an aspect of the present invention, the thermal connection portion of the heat-dissipating member is a projection that is a projecting portion, the thermal connection portion of the receiving member is a housing portion that is able to receive the projection with a gap in between, and the gap is filled with the soft thermally conductive member.

In the heat conduction structure according to an aspect of the present invention, the housing portion is a recess forming a groove.

In the heat conduction structure according to an aspect of the present invention, the thermal connection portion of the heat-dissipating member is a surface, the thermal connection portion of the receiving member is a surface facing the surface of the thermal connection portion of the heat-dissipating member, and the soft thermally conductive member is packed between the surface of the thermal connection portion of the heat-dissipating member and the surface of the thermal connection portion of the receiving member.

### [Advantageous Effects of the Invention]

The heat conduction structure according to the present invention enables a favorable heat dissipation.

### [Brief Description of the Drawings]

[Fig. 1] Fig. 1 is a cross-sectional view illustrating a schematic configuration of a heat conduction structure according to a first embodiment of the present invention.
[Fig. 2] Fig. 2 is a cross-sectional view illustrating a schematic configuration of a heat conduction structure according to a second embodiment of the present invention.
[Fig. 3] Fig. 3 is a cross-sectional view illustrating a schematic configuration of a modification example of the heat conduction structure according to the second embodiment of the present invention.
[Fig. 4] Fig. 4 is a cross-sectional view illustrating a schematic configuration of a practical example of the heat conduction structure according to the first embodiment of the present invention.
[Fig. 5] Fig. 5 is a cross-sectional view illustrating a schematic configuration of a practical example of the heat conduction structure according to the second embodiment of the present invention.

### [Description of Embodiments]

Description will be made below on embodiments of the present invention with reference to the drawings.

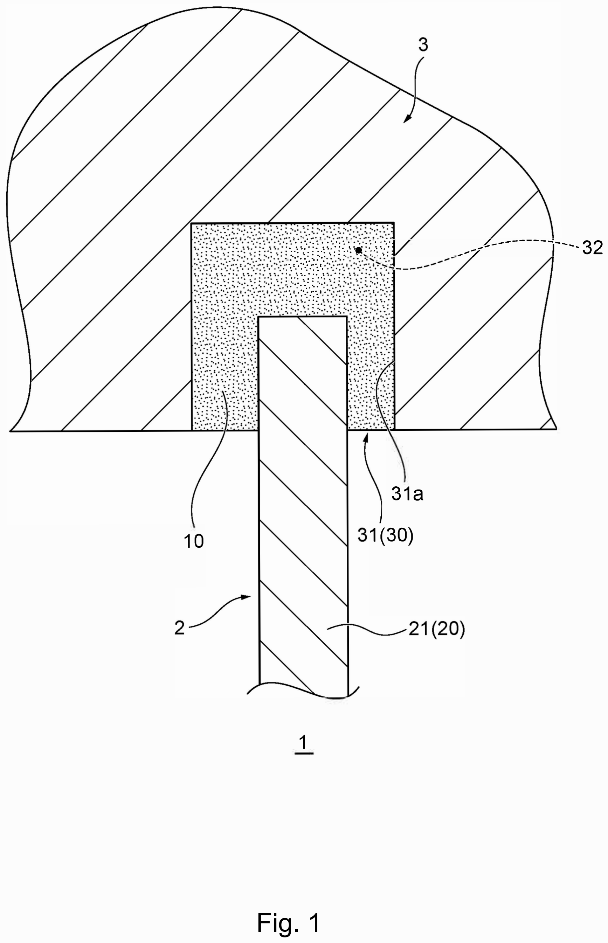

A heat conduction structure according to the present invention is a heat conduction structure for conducting heat of a heat-dissipating member to a receiving member. The heat-dissipating member is a member on a side from which heat is to be dissipating, whereas the receiving member is a member that receives the heat from the heat-dissipating member. The heat-dissipating member is, for example, a member in a heat-generating device, component, or the like. The receiving member is also, for example, a member near the heat-dissipating member. Fig. 1 is a cross-sectional view illustrating a schematic configuration of the heat conduction structure 1 according to the first embodiment of the present invention.

As illustrated in Fig. 1, the heat conduction structure 1 includes a soft thermally conductive member10, which is a soft member with thermally conductive properties. The soft thermally conductive member 10 is a member that is able to maintain its shape. The soft thermally conductive member 10 is packed between the heat-dissipating member 2 and the receiving member 3. A specific description will be made below on the heat conduction structure 1.

The heat-dissipating member 2 and the receiving member 3 include thermal connection portions 20, 30, which are portions for mutual thermal connection, respectively, as illustrated in, for example, Fig. 1. The soft thermally conductive member 10 is packed between the thermal connection portion 20 of the heat-dissipating member 2 and the thermal connection portion 30 of the receiving member 3.

The thermal connection portion 20 of the heat-dissipating member 2 is specifically, for example, a projection 21, which is a projecting portion, as illustrated in Fig. 1. Moreover, the thermal connection portion 30 of the receiving member 3 is specifically, for example, a housing portion 31, which is able to receive the projection 21 with a gap 32 in between, as illustrated in Fig. 1. The gap 32 between the projection 21 and the housing portion 31 is filled with the soft thermally conductive member 10. The housing portion 31 is, for example, a recess forming a groove 31a.

The receiving member 3 is made of, for example, a resin with thermally conductive properties (a thermally conductive resin). Moreover, for example, a thermal conductivity of the receiving member 3, that is, a thermal conductivity of the thermally conductive resin that is the material of the receiving member 3, is lower than a thermal conductivity of the heat-dissipating member 2. Moreover, the thermal conductivity of the thermally conductive resin that is the material of the receiving member 3 is specifically, for example, lower than a thermal conductivity of the thermal connection portion 20 of the heat-dissipating member 2. Although the thermal conductivity of the thermally conductive resin forming the receiving member 3 is thus lower than the thermal conductivity of the heat-dissipating member 2, the thermally conductive resin forming the receiving member 3 is, for example, a resin with a high thermal conductivity exhibiting excellent thermally conductive properties.

The thermally conductive resin forming the receiving member 3 is, for example, a composite material of a resin, such as polyphenylene sulfide (PPS), polybutylene terephthalate (PBT), polypropylene (PP), or liquid crystal polymer (LCP), and thermally conductive particles (filler) with high thermally conductive properties. The thermally conductive particles with high thermally conductive properties may be electrically conductive particles (for example, an electrically conductive filler) or may be insulating particles (for example, an insulating filler). Examples of a material of the electrically conductive particles may include metal and carbon, and the electrically conductive particles may be particles made of a single material or particles of a combination of particles made of two or more materials. Specific examples of the electrically conductive particles may include aluminum particles, copper particles, silver particles, carbon particles, carbon fibers, diamond, and graphite. Examples of a material of the insulating particles may include metal oxides, metal nitrides, metal carbides, and metal hydroxides, and the insulating particles may be particles made of a single material or particles of a combination of particles made of two or more materials. Specific examples of the thermally conductive particles may include aluminum oxide particles, magnesium oxide particles, zinc oxide particles, boron nitride particles, aluminum nitride particles, silicon carbide particles, and aluminum hydroxide particles.

In the heat conduction structure 1, the projection 21 of the heat-dissipating member 2 is received in the groove 31a of the housing portion 31 of the receiving member 3 as illustrated in Fig. 1. Moreover, the projection 21 is not in contact with the groove 31a and the gap 32 is formed between the projection 21 and the groove 31a. The groove 31a has, for example, a shape corresponding to that of the projection 21 and the entire surface of the groove 31a is configured to face the entire surface of the projection 21. As illustrated in Fig. 1, the gap 32 extends between the entire surface of the projection 21 within the groove 31a and the entire surface of the groove 31a. The gap 32 is filled with the soft thermally conductive member 10 as described above. Consequently, the soft thermally conductive member 10 is in contact with the entire surface or substantially the entire surface of the projection 21 within the groove 31a and the entire surface or substantially the entire surface of the groove 31a as illustrated in Fig. 1. It should be noted that the whole of the gap 32 does not have to be filled with the soft thermally conductive member 10.

It should be noted that the shape of the groove 31a of the housing portion 31 is not limited to the above-described shape corresponding to that of the projection 21. For example, the shape of the groove 31a may be a shape longer than that of the projection 21 in a direction perpendicular to an insertion direction of the projection 21. In this case, for example, the whole of the groove 31a does not have to be filled with the soft thermally conductive member 10. Moreover, for example, the groove 31a partially may have a shape allowing for contact with the projection 21.

The soft thermally conductive member 10 is a member that is soft and able to maintain its shape as described above. Specifically, the soft thermally conductive member 10 is a member in paste form, which does not flow at least in a temperature range where the heat conduction structure 1 is to be used and does not deform or substantially does not deform without application of an external force but plastically deforms under an external force with a predetermined magnitude. The substance in paste form does not include: a substance that is not able to maintain its shape such as a substance in liquid or grease form; a substance that is not able to form a lump such as a substance in powder form; and a substance in solid form. The soft thermally conductive member 10 is, for example, a composition in paste form with thermally conductive properties. The soft thermally conductive member 10 is specifically, for example, a composition containing a component that gives a paste form and a component with thermally conductive properties.

The soft thermally conductive member 10 is, for example, a composition containing a grease and thermally conductive particles. The soft thermally conductive member 10 specifically contains, for example, 550 to 800 parts by mass of the thermally conductive particles with respect to 100 parts by mass of the grease. The thermally conductive particles include, for example, first thermally conductive particles having an average particle size in a range from 30 to 55 µm, inclusive, and second thermally conductive particles having an average particle size in a range from 3 to 15 µm, inclusive, and a blending ratio between the first thermally conductive particles and the second thermally conductive particles is in a range from 7:3 to 5:5, inclusive, on a mass basis. Moreover, the soft thermally conductive member 10 has, for example, a Type OO hardness of 70 or less and an adhesive force of 10 N or less at a temperature of 25 degrees C as measured over, as a unit area, a 13-mm-diameter circular range.

The grease of the soft thermally conductive member 10 is a semi-solid or solidified substance in which a thickener is dispersed in a base oil. The types of the base oil and the thickener are not particularly limited, and base oils and the thickeners appropriately formulated so that the above-described numerical range of the adhesive force is satisfied are usable. Examples of the base oil may include mineral oils, synthetic oils, other animal or vegetable oils, and mixtures thereof. The type of the thickener is also not particularly limited, and for example, conventionally known thickeners, such as metal soap thickeners including lithium soaps and calcium soaps and non-soap thickeners including silica, urea, PTFE, or bentonite, are usable.

The grease of the soft thermally conductive member 10 may include a grease whose base oil is a silicone oil, such as a silicone grease. Examples of the silicone grease may include "HVG grease (trade name)" manufactured by Dow Corning Toray Co., Ltd. Moreover, a penetration of the grease is, for example, in a range from 100 to 400, inclusive, in the immiscible state and is, for example, in a range from 150 to 300, inclusive. As for measurement of the penetration of the grease, it may be measured using a penetrometer in accordance with JIS K 2200-2013. Examples of the penetrometer include a needle penetration tester "RPM-201" manufactured by RIGO CO., LTD.

The soft thermally conductive member 10 contains the thermally conductive particles in addition to the grease as described above. By containing an appropriate amount of such thermally conductive particles, it is possible to improve shape retention and provide the soft thermally conductive member 10 in paste form while the hardness is low. It is also possible to achieve a desired value of a thermal conductivity of the soft thermally conductive member 10. The thermally conductive particles are, for example, in a range from 550 to 800 parts by mass, inclusive, with respect to 100 parts by mass of the grease as described above and, for example, in a range from 600 to 700 parts by mass. At an extremely low blending amount of the thermally conductive particles, there is a possibility that the thermal conductivity and the shape retention decrease, for example, making an effect in reducing the adhesiveness of the soft thermally conductive member 10 unlikely to be exhibited. In contrast, the thermal conductivity and the shape retention of the soft thermally conductive member 10 increase with an increase in blending amount of the thermally conductive particles; however, at an extremely high blending amount of the thermally conductive particles, there is a possibility that the hardness of the soft thermally conductive member 10 increases and, consequently, integration between the grease and the thermally conductive particles decreases, making the shape of the soft thermally conductive member 10 unlikely to be maintained.

As described above, the soft thermally conductive member 10 includes, for example, the first thermally conductive particles having an average particle size in a range from 30 to 55 µm, inclusive, and the second thermally conductive particles having an average particle size in a range from 3 to 15 µm, inclusive. As seen from the above, the soft thermally conductive member 10 contains two types of thermally conductive particle powders different in particle size, which increases a packing performance of the thermally conductive particles within the soft thermally conductive member 10, allowing for an improved shape retention while the hardness is low. By sphering the two types of thermally conductive particle powder different in particle size, closest packing of the thermally conductive particles is achieved. It should be noted that the particle sizes of the thermally conductive particles are values measured using a laser diffraction particle size distribution measurement method (device: Microtrac).

The blending ratio between the first thermally conductive particles and the second thermally conductive particles is in a range from 7:3 to 5:5, inclusive, on a mass basis as described above. At a blending ratio outside the above-described range, the filling performance with the thermally conductive particles decreases, the hardness of the thermally conductive member 10 increases, and the integration between the grease and the thermally conductive particles decreases, making the shape of the soft thermally conductive member 10 unlikely to be maintained. The thermally conductive particles may be electrically conductive particles (for example, an electrically conductive filler) or may be insulating particles (for example, an insulating filler). Examples of a material of the electrically conductive particles may include metal and carbon, and the electrically conductive particles may be particles made of a single material or particles of a combination of particles made of two or more materials. Specific examples of the electrically conductive particles may include aluminum particles, copper particles, silver particles, carbon particles, carbon fibers, diamond, and graphite.

In a case where the thermally conductive particles are insulating particles (for example, an insulating filler), the thermally conductive particles are, for example, particles made of at least one material selected from the group consisting of metal oxides, metal nitrides, metal carbides, and metal hydroxides. The thermally conductive particles may be any one of alumina particles, magnesia particles, zinc oxide particles, boron nitride particles, aluminum nitride particles, silicon carbide particles, and aluminum hydroxide particles. The first thermally conductive particles and the second thermally conductive particles may be particles made of a single material or particles of a combination of particles made of two or more materials.

The average particle size of the first thermally conductive particles is, for example, in a range from 30 to 55 µm, inclusive, as described above. The average particle size of the first thermally conductive particles may be in a range from 35 to 50 µm, inclusive, or may be 45 µm. Moreover, the average particle size of the second thermally conductive particles may be in a range from 3 to 15 µm, inclusive, as described above. The average particle size of the second thermally conductive particles may be in a range from 4.5 to 9 µm, inclusive, or may be 5 µm. It should be noted that the average particle sizes of the first thermally conductive particles and the second thermally conductive particles are cumulative average values based on volume measured using a laser diffraction particle size distribution measurement method (device: Microtrac).

The type OO hardness of the soft thermally conductive member 10 is, for example, 70 or less as described above but may be in a range from 0.5 to 60, inclusive, or in a range from 0.5 to 50, inclusive. The type OO hardness may be measured using a hardness tester in accordance with ASTM-D 2240-2015. A durometer "GSD-754K (trade name)" manufactured by TECLOCK Co., Ltd. is usable as the hardness tester.

The adhesive force of the soft thermally conductive member 10 at a temperature of 25 degrees C as measured over, as a unit area, a 13-mm-diameter circular range is, for example, 10 N or less as described above and may be in a range from 0.1 to 9 N, inclusive, or may be in a range from 2 to 9 N, inclusive. The adhesive force may be measured using a material tester including a rod-shaped measurement probe and a sample stage. For example, a compact benchtop testing machine "EZ-SX (trade name)" manufactured by Shimadzu Corporation is usable as the material tester. The soft thermally conductive member 10, which is a measurement sample, may be in the shape of a 13-mm-diameter, 1-mm-thick disc. Such a measurement sample is placed on an end surface of the sample stage to measure the adhesive force. In measuring the adhesive force, the measurement probe is pressed into the measurement sample placed on the sample stage until a specified compressive load is reached, a maximum load [N] is measured when the measurement probe is pulled up, and the maximum load [N] is defined as an adhesive force [N] of the soft thermally conductive member 10, which is the measurement sample. Measurement conditions for the measurement of the adhesive force may be as follows: the temperature is 25 degrees C; a compression speed while the measurement probe is pressed in is 1 mm/min; the compressive load is 5 N; and a pull-up speed while the measurement probe is pulled up is 1000 mm/min. The adhesive force of the soft thermally conductive member 10 thus measured is 10 N or less.

The thermal conductivity of the soft thermally conductive member 10 is lower than the thermal conductivity of the heat-dissipating member 2 as described above. The thermal conductivity of the soft thermally conductive member 10 is, for example, 0.4 W/m·K or more, for example, in a range from 2 to 4 W/m·K, inclusive, or, for example, in a range from 2 to 3.5 W/m·K, inclusive. It should be noted that the thermal conductivity of the soft thermally conductive member 10 may be measured using a thermal conductivity measurement device. Examples of the thermal conductivity measurement device may include, for example, "TCi-3-A (trade name)" manufactured by C-Therm Technologies Ltd.

The soft thermally conductive member 10 may contain a colorant, a base oil diffusion inhibitor, a thickener, etc. It should be noted that a known soft conductive member in paste form, such as a soft conductive member in paste form disclosed in International Publication No. WO 2022/186046, is usable as the soft thermally conductive member 10.

The soft thermally conductive member 10 may be injected to fill the gap 32 or may be applied to the groove 31a to fill the gap 32. Alternatively, the soft thermally conductive member 10 may be applied to the projection 21 to fill the gap 32. Alternatively, the gap 32 may be filled with the soft thermally conductive member 10 by any other method.

The heat conduction structure 1 according to the present embodiment has a configuration as described above, in which the soft thermally conductive member 10 filling the gap 32 is in contact with the entire surface or substantially the entire surface of the projection 21 of the heat-dissipating member 2 within the groove 31a and also in contact with the entire surface or substantially the entire surface of the groove 31a of the receiving member 3. Moreover, the soft thermally conductive member 10 is soft, does not flow at least in the temperature range where the heat conduction structure 1 is to be used, and does not deform or substantially does not deform without application of an external force but plastically deforms under an external force with the predetermined magnitude. As seen from the above, in the heat conduction structure 1, the projection 21 of the heat-dissipating member 2 is in closer contact with the groove 31a of the receiving member 3 through the soft thermally conductive member 10. Therefore, the heat conduction structure 1 enables a high thermally conductive efficiency between the heat-dissipating member 2 and the receiving member 3.

Moreover, the soft thermally conductive member 10 fills the gap 32 to maintain the shape thereof. Thus, the soft thermally conductive member 10 is in contact with the entire surface or substantially the entire surface of the projection 21 within the groove 31a and also in contact with the entire surface or substantially the entire surface of the groove 31a irrespective of the shape of the projection 21 of the heat-dissipating member 2 and the shape of the housing portion 31 of the receiving member 3. Therefore, the projection 21 of the heat-dissipating member 2 is not required to have a high dimensional accuracy and the housing portion 31 of the receiving member 3 is also not required to have a high dimensional accuracy as in a case where the projection 21 of the heat-dissipating member 2 is brought into direct contact with the housing portion 31 of the receiving member 3 to form a thermal conduction path.

Moreover, even in a case where the projection 21 of the heat-dissipating member 2 or the housing portion 31 of the receiving member 3 deforms or in a case where a relative position between the projection 21 of the heat-dissipating member 2 and the housing portion 31 of the receiving member 3 changes, the soft thermally conductive member 10 follows the deformation or the change in relative position, maintaining a state of contact with the entire surface or substantially the entire surface of the projection 21 within the groove 31a and a state of contact with the entire surface or substantially the entire surface of the groove 31a. Therefore, even in a case where the projection 21 of the heat-dissipating member 2 or the housing portion 31 of the receiving member 3 deforms or in a case where a relative position between the projection 21 of the heat-dissipating member 2 and the housing portion 31 of the receiving member 3 changes, the heat conduction structure 1 enables maintenance of a high thermally conductive efficiency between the heat-dissipating member 2 and the receiving member 3.

As seen from the above, the heat conduction structure 1 according to the first embodiment of the present invention makes it possible to achieve a favorable heat dissipation.

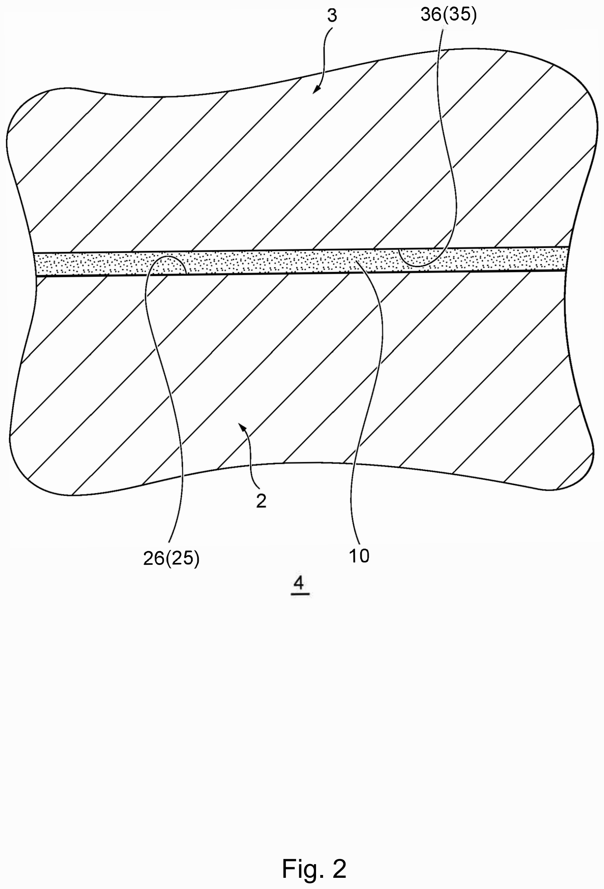

Next, description will be made on a second embodiment of the present invention. Fig. 2 is a cross-sectional view illustrating a schematic configuration of a heat conduction structure 4 according to the second embodiment of the present invention. The heat conduction structure 4 according to the present embodiment is different from the above-described heat conduction structure 1 in the form of the thermal connection portion. Hereinbelow, out of components of the heat conduction structure 4, the same or a functionally similar component as or to that of the above-described heat conduction structure 1 is designated by the same sign and a description thereof is omitted; therefore, description will be made on a different component.

In the heat conduction structure 4, the soft thermally conductive member 10 is also packed between the heat-dissipating member 2 and the receiving member 3 as illustrated in Fig. 2. The heat-dissipating member 2 and the receiving member 3 include thermal connection portions 25, 35, which are portions for mutual thermal connection, respectively, as illustrated in, for example, Fig. 2. The soft thermally conductive member 10 is packed between the thermal connection portion 25 of the heat-dissipating member 2 and the thermal connection portion 35 of the receiving member 3.

The thermal connection portion 25 of the heat-dissipating member 2 is a surface 26 as illustrated in Fig. 2. Moreover, the thermal connection portion 35 of the receiving member 3 is a surface 36 facing the surface 26, which is the thermal connection portion 25 of the heat-dissipating member 2, as illustrated in Fig. 2. The soft thermally conductive member 10 is packed between the surface 26, which is the thermal connection portion 25 of the heat-dissipating member 2, and the surface 36, which is the thermal connection portion 35 of the receiving member 3. It should be noted that the surface 26 and the surface 36 are not necessarily a smooth surface and may be a surface in any form, such as an uneven surface. Moreover, the surface 26 and the surface 36 are not necessarily a continuous surface and may be a surface including a plurality of separate surfaces.

In the heat conduction structure 4, the soft thermally conductive member 10 is in contact with the entire or substantially the entire surface 26 of the heat-dissipating member 2 and also in contact with the entire or substantially the entire surface 36 of the receiving member 3. This results in a closer contact between the surface 26 of the heat-dissipating member 2 and the surface 36 of the receiving member 3 through the soft thermally conductive member 10. Therefore, the heat conduction structure 4 also produces an effect similar to that of the above-described heat conduction structure 1, enabling a high thermally conductive efficiency between the heat-dissipating member 2 and the receiving member 3.

As seen from the above, the heat conduction structure 4 according to the second embodiment of the present invention makes it possible to achieve a favorable heat dissipation.

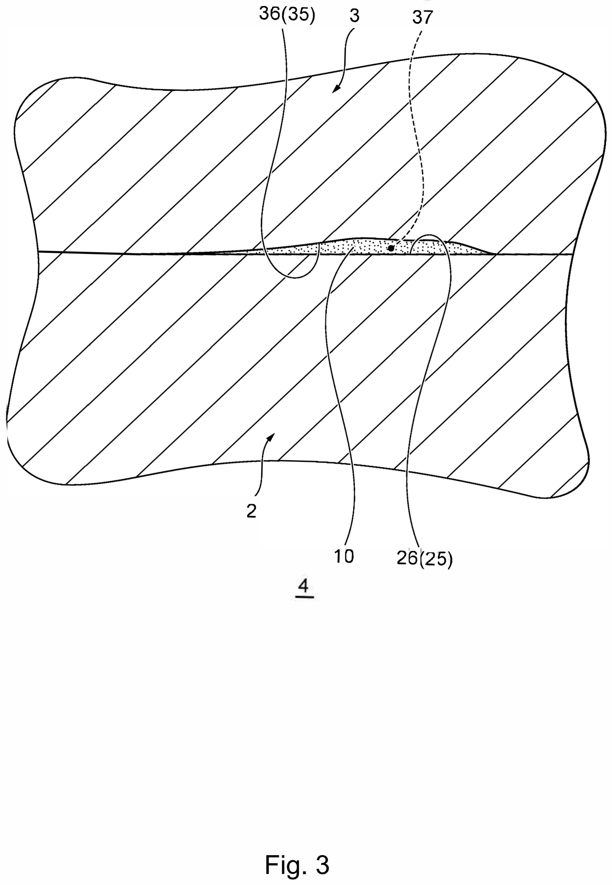

Next, description will be made on a modification example of the heat conduction structure 4 according to the second embodiment of the present invention. Fig. 3 is a cross-sectional view illustrating a schematic configuration of the modification example of the heat conduction structure 4. As illustrated in Fig. 3, in the heat conduction structure 4 according to the modification example, a part of the surface 26, which is the thermal connection portion 25 of the heat-dissipating member 2, is in direct contact with a part of the surface 36, which is the thermal connection portion 35 of the receiving member 3, and a gap 37 is formed between a part of the surface 26 of the thermal connection portion 25 of the heat-dissipating member 2 and a part of the surface 36 of the thermal connection portion 35 of the receiving member 3. The gap 37 is filled with the soft thermally conductive member 10.

In the heat conduction structure 4 according to the modification example, the soft thermally conductive member 10 is also in contact with the entire surface or substantially the entire surface of the part of the surface 26 of the heat-dissipating member 2 forming the gap 37 and in contact with the entire surface or substantially the entire surface of the part of the surface 36 of the receiving member 3 forming the gap 37. Thus, the direct contact and the contact through the soft thermally conductive member 10 result in a closer contact between the surface 26 of the heat-dissipating member 2 and the surface 36 of the receiving member 3. Therefore, the heat conduction structure 4 according to the modification example also enables a high thermally conductive efficiency between the heat-dissipating member 2 and the receiving member 3.

For example, in a case where a dimensional accuracy of the surface 36 of the receiving member 3 is low or in a case where the surface 36 of the receiving member 3 deforms, the gap 37 is formed between a part of the surface 26 of the heat-dissipating member 2 and a part of the surface 36 of the receiving member 3 as in the heat conduction structure 4 according to the modification example. Moreover, for example, in a case where a dimensional accuracy of the surface 26 of the heat-dissipating member 2 is low or in a case where the surface 26 of the heat-dissipating member 2 deforms, the gap 37 is formed between a part of the surface 26 of the heat-dissipating member 2 and a part of the surface 36 of the receiving member 3 as in the heat conduction structure 4 according to the modification example. Even in such a case, the soft thermally conductive member 10 filling the gap 37 achieves a closer contact between the surface 26 of the heat-dissipating member 2 and the surface 36 of the receiving member 3. This makes it possible to achieve a high thermally conductive efficiency between the heat-dissipating member 2 and the receiving member 3. Moreover, the heat conduction structure 4 eliminates the necessity for the surface 26 of the heat-dissipating member 2 to have a high dimensional accuracy and the necessity for the surface 36 of the receiving member 3 to have a high dimensional accuracy.

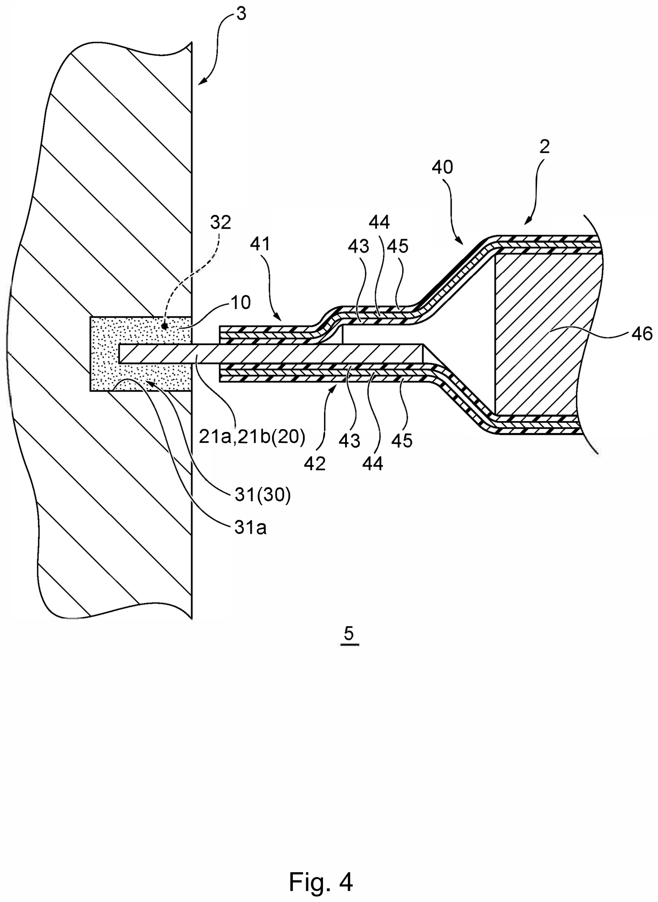

Next, description will be made on a practical example of the heat conduction structure 1 according to the first embodiment of the present invention. Fig. 4 is a cross-sectional view illustrating a schematic configuration of a practical example of the heat conduction structure 1 according to the first embodiment of the present invention. The heat conduction structure 1 according to a practical example is a heat conduction structure for performing, in a secondary battery including a laminated cell stacked in an enclosure, heat dissipation of the laminated cell. It should be noted that the laminated cell is a battery cell in which a laminated film including insulating resin films bonded to opposite surfaces of a metal foil such as an aluminum foil or a stainless steel foil is used as an exterior body for housing a battery element. It should be noted that Fig. 4 illustrates a part of the secondary battery.

In the heat conduction structure 1 according to the present practical example, the heat-dissipating member 2 is a laminated cell of a secondary battery 5 and the receiving member 3 is an enclosure for the secondary battery 5. The thermal connection portion 20 of the heat-dissipating member (the laminated cell) 2 is a positive electrode current collector tab 21a and a negative electrode current collector tab 21b projecting from an exterior body 40 of the laminated cell 2 including laminated films 41, 42. The positive electrode current collector tab 21a and the negative electrode current collector tab 21b are the projections 21 of the heat conduction structure 1. It should be noted that the laminated films 41, 42 are, for example, a film formed by stacking a metal sheet 44 such as an aluminum foil, an inner thermoplastic resin layer 43, and an outer insulating resin layer 45 as illustrated in Fig. 4. Moreover, an electrode stacked portion 46 is housed in the exterior body 40. The electrode stacked portion 46 has, for example, a configuration in which a positive electrode plate and a negative electrode plate are alternately stacked with a separator in between.

Moreover, the thermal connection portion 30 of the receiving member (the enclosure) 3 is the housing portion 31 formed in the enclosure 3. The housing portion 31, which is formed to be able to house the positive electrode current collector tab 21a and the negative electrode current collector tab 21b of the laminated cell 2 with the gap 32 in between, is specifically, for example, a recess forming the groove 31a. The housing portion 31 is provided with respect to each laminated cell 2. Moreover, the housing portion 31 may be provided for each of the positive electrode current collector tab 21a and the negative electrode current collector tab 21b or the single housing portion 31 may be provided with respect to the positive electrode current collector tab 21a and the negative electrode current collector tab 21b.

The enclosure 3 is made of, for example, a thermally conductive resin and a thermal conductivity of the enclosure 3 is lower than a thermal conductivity of the positive electrode current collector tab 21a and the negative electrode current collector tab 21b of the laminated cell 2.

As illustrated in Fig. 4, the positive electrode current collector tab 21a and the negative electrode current collector tab 21b of the laminated cell 2 are received in the groove 31a of the enclosure 3. The gap 32 has expanded between the entire surface of the positive electrode current collector tab 21a within the groove 31a and the entire surface of the groove 31a facing the positive electrode current collector tab 21a, and the gap 32 has expanded between the entire surface of the negative electrode current collector tab 21b within the groove 31a and the entire surface of the groove 31a facing the negative electrode current collector tab 21b. The gap 32 is filled with the soft thermally conductive member 10. As illustrated in Fig. 4, the soft thermally conductive member 10 is in contact with the entire surface of the positive electrode current collector tab 21a within the groove 31a, the entire surface of the negative electrode current collector tab 21b within the groove 31a, and the entire surface of the groove 31a. It should be noted that the whole of the gap 32 does not have to be filled with the soft thermally conductive member 10.

As described above, in the secondary battery 5, the soft thermally conductive member 10 filling the gap 32 is in contact with the entire surfaces or substantially the entire surfaces of the positive electrode current collector tab 21a and the negative electrode current collector tab 21b within the groove 31a of the enclosure 3 and in contact with the entire surface or substantially the entire surface of the groove 31a of the enclosure 3. The soft thermally conductive member 10 thus serves to achieve a closer contact between each of the positive electrode current collector tab 21a and the negative electrode current collector tab 21b of the laminated cell 2 and the groove 31a of the enclosure 3 in the secondary battery 5 as in the heat conduction structure 1 described above. Consequently, in the secondary battery 5, the heat conduction structure 1 enables a high thermal conductivity between the laminated cell 2 and the enclosure 3, improving a heat dissipation effect from the laminated cell 2 to the enclosure 3. Moreover, the heat conduction structure 1 enables adding heat dissipation through the positive electrode current collector tab 21a and the negative electrode current collector tab 21b to the laminated cell 2 to further increase a heat dissipation performance relative to the laminated cell 2. This makes it possible to favorably dissipate heat inside the laminated cell 2 into the enclosure 3 through the soft thermally conductive member 10 even though the temperature of the electrode stacked portion 46 of the laminated cell 2 rises with an increase in output power of the secondary battery 5. Therefore, it is possible to reduce heat damage to the laminated cell 2 and use the secondary battery 5 at a higher output power, accordingly.

Moreover, the thermal conductivity of the thermally conductive resin forming the enclosure 3 is lower than the thermal conductivity of the positive electrode current collector tab 21a and the negative electrode current collector tab 21b of the laminated cell 2 as described above. This allows for a more favorable dissipation of heat inside the laminated cell 2 to the enclosure 3 through the soft thermally conductive member 10.

It should be noted that the heat conduction structure 1 in the laminated cell 2 of the above-described secondary battery 5 is a practical example of the heat conduction structure 1 according to the first embodiment of the present invention, and a specific application target for the heat conduction structure 1 according to the first embodiment of the present invention is not limited to the laminated cell 2 of the above-described secondary battery 5 and may include parts of other components and devices, such as a bus-bar and a connector in an electronic component and an electronic device.

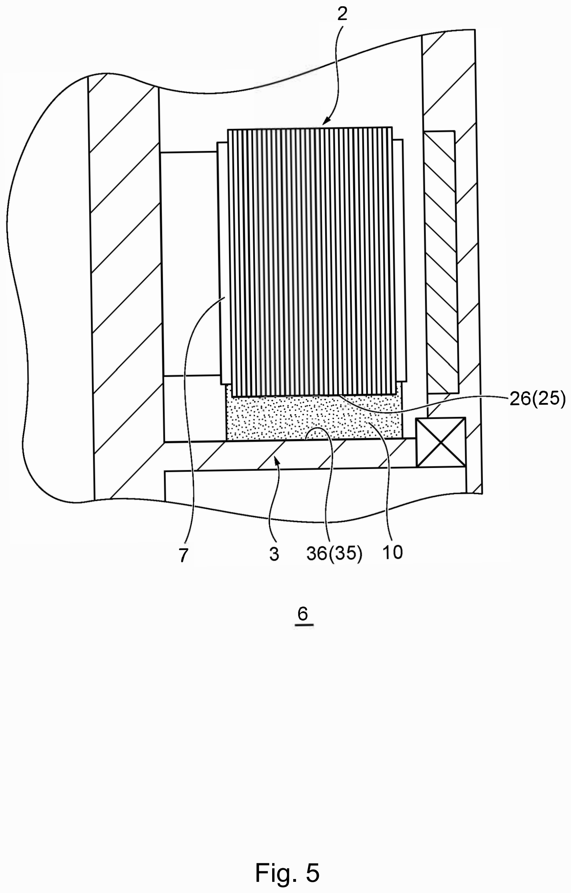

Next, description will be made on a practical example of the heat conduction structure 4 according to the second embodiment of the present invention. Fig. 5 is a cross-sectional view illustrating a schematic configuration of a practical example of the heat conduction structure 4 according to the second embodiment of the present invention. The heat conduction structure 4 according to a practical example is a heat conduction structure for performing heat dissipation of a coil of a brushless motor in an in-wheel motor.

In the heat conduction structure 4 according to the present practical example, the heat-dissipating member 2 is a stator coil of a brushless motor 6 and the receiving member 3 is a stator holder of the brushless motor 6. The thermal connection portion 25 of the heat-dissipating member (the stator coil) 2 is a surface (a coil bundle surface) 26 of a bundle of stator coils 2 made of a bundle of stator coils 2 wound on each core 7 of the stator. Moreover, the thermal connection portion 35 of the receiving member (the stator holder) 3 is a surface 36 formed in the stator holder 3. The surface 36 of the stator holder 3 faces the coil bundle surface 26. The soft thermally conductive member 10 is packed between the coil bundle surface 26 of the stator coil 2 and the surface 36 of the stator holder 3.

In the heat conduction structure 4, the soft thermally conductive member 10 is in contact with the entire or substantially the entire coil bundle surface 26 of the stator coil 2 and in contact with the entire or substantially the entire surface 36 of the stator holder 3. The coil bundle surface 26 of the stator coil 2 is thus thermally connected to the surface 36 of the stator holder 3 through the soft thermally conductive member 10. Moreover, the coil bundle surface 26 of the stator coil 2 is in closer contact with the surface 36 of the stator holder 3 through the soft thermally conductive member 10. It should be noted that a space between the stator coils 2 wound on respective adjacent ones of the cores 7 of the stator may be filled with the soft thermally conductive member 10.

The stator holder 3 is made of, for example, a thermally conductive resin and a thermal conductivity of the stator holder 3 is lower than a thermal conductivity of the stator coil 2 of the brushless motor 6.

As described above, in the brushless motor 6 of the in-wheel motor, the soft thermally conductive member 10 is in contact with the entire or substantially the entire coil bundle surface 26 of the stator coil 2 and in contact with the entire surface or substantially the entire surface 36 of the stator holder 3. As seen from the above, the soft thermally conductive member 10 serves to achieve a closer contact between the coil bundle surface 26 of the stator coil 2 and the surface 36 of the stator holder 3. Therefore, the heat conduction structure 4 makes it possible to achieve a high thermally conductive efficiency between the stator coil 2 and the stator holder 3 in the brushless motor 6 of the in-wheel motor to improve a heat dissipation effect from the stator coil 2 to the stator holder 3. The heat conduction structure 4 also makes it possible to add heat dissipation through the coil bundle surface 26 of the stator coil 2 to the brushless motor 6 to further increase the heat dissipation performance of the brushless motor 6.

Moreover, the thermal conductivity of the thermally conductive resin forming the stator holder 3 is lower than the thermal conductivity of the stator coil 2 of the brushless motor 6 as described above. This allows for a more favorable dissipation of heat of the stator coil 2 to the stator holder 3 through the soft thermally conductive member 10.

It should be noted that the above-described heat conduction structure 4 in the brushless motor 6 of the in-wheel motor may be packed between the coil bundle surface 26 facing the core 7 or an insulator (not illustrated) of the stator coil 2 and the core 7 or the insulator (not illustrated). Moreover, the above-described heat conduction structure 4 in the brushless motor 6 of the in-wheel motor is a practical example of the heat conduction structure 4 according to the second embodiment of the present invention, and a specific application target for the heat conduction structure 4 according to the second embodiment of the present invention is not limited to the above-described brushless motor 6 in the in-wheel motor and may include parts of other components and devices such as a bus-bar and a connector of an electronic component and an electronic device and a slot liner and a rotor of a motor.

The present invention is described through the above-described embodiments hereinabove but the technical scope of the present invention is not limited to the scope according to the above-described embodiments. It is obvious to those skilled in the art that a variety of modifications or improvements may be added to the above-described embodiments. It is obvious from the recitation in claims that an embodiment added with such a modification or an improvement is also within the technical scope of the present invention.

The embodiments described above are intended to facilitate the understanding of the present invention but not intended for a limited interruption of the present invention. Furthermore, the above-described embodiments are not intended to limit an application target for which the present invention is to be applied and the present invention may encompass, as the application target, any and all objects. The components of the above-described embodiments and the locations, materials, conditions, shapes, sizes, and the like thereof are not limited to those described by way of example and may be modified, if necessary. For example, the present invention encompasses a difference generated in implementation, such as a manufacturing tolerance. Furthermore, within the scope of technical consistency, the components described in different embodiments may be partially replaced or combined. Furthermore, the individual components may be selectively combined, if necessary, to achieve at least some of the problems to be solved and the effects described above.

### [Reference Signs List]

1, 4 heat conduction structure, 2 heat-dissipating member, laminated cell, stator coil, 3 receiving member, enclosure, stator holder, 5 secondary battery, 6 brushless motor, 7 core, 10 soft thermally conductive member, 20, 25 thermal connection portion, 21 projection, 21a positive electrode current collector tab, 21b negative electrode current collector tab, 26 surface, coil bundle surface, 30, 35 thermal connection portion, 31 housing portion, 31a groove, 32 gap, 36 surface, 37 gap, 40 exterior body, 41, 42 laminated film, 43 thermoplastic resin layer, 44 metal sheet, 45 insulating resin layer, 46 electrode stacked portion

## Claims

1. A heat conduction structure for conducting heat of a heat-dissipating member to a receiving member, the heat conduction structure comprising
a soft thermally conductive member that is a soft member with thermally conductive properties, wherein
the soft thermally conductive member is a member able to maintain a shape, and
the soft thermally conductive member is packed between the heat-dissipating member and the receiving member.

2. The heat conduction structure according to claim 1, wherein
a thermal conductivity of the soft thermally conductive member is lower than a thermal conductivity of the heat-dissipating member.

3. The heat conduction structure according to claim 1, wherein
the soft thermally conductive member is a composition in paste form with thermally conductive properties.

4. The heat conduction structure according to claim 3, wherein
the soft thermally conductive member includes a grease and thermally conductive particles.

5. The heat conduction structure according to claim 1, wherein
the receiving member is made of a resin with thermally conductive properties, and
a thermal conductivity of the receiving member is lower than a thermal conductivity of the heat-dissipating member.

6. The heat conduction structure according to claim 1, wherein
the heat-dissipating member and the receiving member include respective thermal connection portions that are portions for mutual thermal connection, and
the soft thermally conductive member is packed between the thermal connection portion of the heat-dissipating member and the thermal connection portion of the receiving member.

7. The heat conduction structure according to claim 6, wherein
the thermal connection portion of the heat-dissipating member is a projection that is a projecting portion,
the thermal connection portion of the receiving member is a housing portion that is able to receive the projection with a gap in between, and
the gap is filled with the soft thermally conductive member.

8. The heat conduction structure according to claim 7, wherein
the housing portion is a recess forming a groove.

9. The heat conduction structure according to claim 6, wherein
the thermal connection portion of the heat-dissipating member is a surface,
the thermal connection portion of the receiving member is a surface facing the surface of the thermal connection portion of the heat-dissipating member, and
the soft thermally conductive member is packed between the surface of the thermal connection portion of the heat-dissipating member and the surface of the thermal connection portion of the receiving member.
